(19) Europäisches Patentamt
European Patent Office
Office européen des brevets

(11) EP 2 082 994 A1

(12) **EUROPEAN PATENT APPLICATION**

(43) Date of publication:
**29.07.2009 Bulletin 2009/31**

(21) Application number: **09250171.7**

(22) Date of filing: **22.01.2009**

(51) Int Cl.:
***C03C 8/22*** *(2006.01)*
***G03F 7/004*** *(2006.01)*
***C03C 8/24*** *(2006.01)*
***H01J 9/26*** *(2006.01)*

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **22.01.2008 KR 20080006708**

(71) Applicant: **Samsung SDI Co., Ltd.**
**Suwon-si, Gyeonggi-do (KR)**

(72) Inventors:
- **Lee, Beom-Wook**
  **Suwon-si, Gyeonggi-do (KR)**
- **Choi, Jong-Seo**
  **Suwon-si, Gyeonggi-do (KR)**
- **Choi, Kwi-Seok**
  **Suwon-si, Gyeonggi-do (KR)**
- **Kang, Dong-Hyun**
  **Suwon-si, Gyeonggi-do (KR)**
- **Lim, Myung-duk**
  **Suwon-si, Gyeonggi-do (KR)**

(74) Representative: **Taor, Simon Edward William**
**Marks & Clerk LLP**
**90 Long Acre**
**London**
**WC2E 9RA (GB)**

# (54) Photosensitive paste composition, barrier ribs prepared using the composition and plasma display panel comprising the barrier ribs

(57) A photosensitive paste composition includes: a fluoride sol dispersed in an organic material; and an inorganic material, wherein an average refractive index of the fluoride sol $N_1$ and an average refractive index of the inorganic material $N_2$ satisfy Mathematical Formula 1 below:

Mathematical Formula 1

$$-0.2 \leq N_1 - N_2 \leq 0.2.$$

By using the photosensitive paste composition, a barrier rib pattern for a high-resolution and high-precision PDP can be prepared through a single light exposure and a PDP having high brightness can be manufactured since the barrier ribs have high reflectance compared to conventional barrier ribs.

FIG. 1

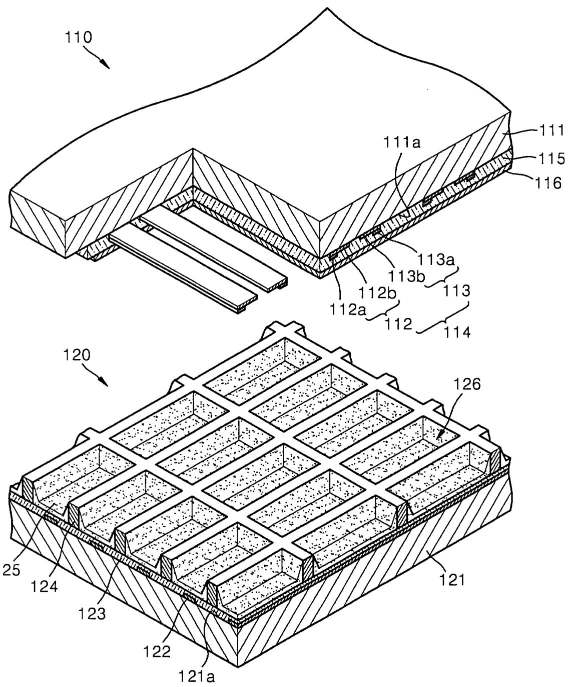


EP 2 082 994 A1

## Description

## BACKGROUND OF THE INVENTION

1. Field of the Invention

Aspects of the present invention relate to a photosensitive paste composition, barrier ribs for a plasma display panel (PDP) prepared using the composition, and a PDP including the barrier ribs. More particularly, aspects of the present invention relate to a photosensitive paste composition that makes it possible to prepare a barrier rib pattern for a high-resolution and high-precision PDP through a single light exposure and to provide barrier ribs having higher reflectance compared to conventional barrier ribs, barrier ribs for a PDP prepared using the composition, and a PDP including the barrier ribs.

2. Description of the Related Art

In a plasma display panel (PDP) structure, barrier ribs are formed on a lower panel (or rear substrate) to secure a discharge space and to inhibit electrical and optical cross-talk between neighboring cells. The pattern of the barrier ribs varies according to the type of the PDP, and may be a stripe-type or a matrix-type. The barrier ribs may also have various sizes (width and pitch).

Barrier ribs may be formed using a sand blasting method, an etching method or a photolithographic method after forming an address electrode on a lower panel and a dielectric material on the address electrode.

Regarding photolithography, a method of forming barrier ribs through a single light exposure process by minimizing the difference between the refractive indexes of organic and inorganic components in order to reduce reflection and scattering at the interface between the organic and inorganic components was disclosed in U.S. Patent No. 6,197,480. U.S. Patent No. 6,117,614 discloses a method of inhibiting oxygen from adversely affecting crosslinking reactions by minimizing the difference between refractive indexes of organic and inorganic components as described in U.S. Patent No. 6,197,480, and using chemically amplified type crosslinking using a photo-acid generator.

According to those disclosed photolithographic methods, a barrier rib having a high-resolution can be manufactured more simply compared to a barrier rib manufactured by sand blasting. However, the photolithographic methods described above have fundamental disadvantages. While a predetermined amount of powder of titania, alumina, yttria or zinc oxide is used when using a sand blasting method or etching in order to improve reflexibility, such powder cannot be used in the single exposure photolithographic method because the powder has a very high refractive index so as to fails to minimize refractive index of organic components and prevents transmission of ultraviolet rays which is irradiated during the light exposure. Therefore, if such a powder is used in the photolithographic methods described above, more than one exposure may be necessary.

## SUMMARY OF THE INVENTION

Aspects of the present invention provide a photosensitive paste composition that makes it possible to prepare a barrier rib pattern of a high-resolution and high-precision plasma display panel (PDP) through a single light exposure and to provide barrier ribs having higher reflectance compared to conventional barrier ribs, barrier ribs for a PDP prepared using the composition, and a PDP including the barrier ribs.

According to an embodiment of the present invention, there is provided a photosensitive paste composition comprising: a fluoride sol dispersed in an organic material; and an inorganic material, wherein an average refractive index of the fluoride sol $N_1$ and an average refractive index of the inorganic material $N_2$ satisfy Mathematical Formula 1 below:

$$-0.2 \leq N_1 - N_2 \leq 0.2.$$

According to another aspect of the present invention, barrier ribs for a plasma display panel (PDP) are prepared by patterning the photosensitive paste composition.

According to another aspect of the present invention, there is provided a plasma display panel (PDP) comprising the barrier ribs.

Additional aspects and/or advantages of the invention will be set forth in part in the description which follows and, in part, will be obvious from the description, or may be learned by practice of the invention.

According to an aspect of the present invention there is provided a photosensitive paste composition as set

out in Claim 1. Preferred features of this aspect are set out in Claims 2 to 19. According to an aspect of the present invention there is provided barrier ribs as set out in any one of Claims 1 to 19. According to an aspect of the present invention there is provided a plasma display panel as set out in Claim 20.

## BRIEF DESCRIPTION OF THE DRAWINGS

These and/or other aspects and advantages of the invention will become apparent and more readily appreciated from the following description of the embodiments, taken in conjunction with the accompanying drawings of which:

FIG. 1 is a perspective view of a plasma display panel (PDP) according to an embodiment of the present invention.

## DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures.

A photosensitive paste composition according to aspects of the present invention includes: a fluoride sol dispersed in an organic material; and an inorganic material, wherein an average refractive index of the fluoride sol $N_1$ and an average refractive index of the inorganic material $N_2$ satisfy Mathematical Formula 1 below:

Mathematical Formula 1

$$-0.2 \leq N_1 - N_2 \leq 0.2$$

The photosensitive paste composition according to aspects of the present invention includes a fluoride sol that is distinguishable from conventional photosensitive paste compositions. The fluoride sol is a sol in which particles of a fluoride compound having a size of several to several tens of nanometers are dispersed in an organic material. The fluoride compound may be dispersed in an organic material in a stable state in which agglomeration or precipitation does not occur and may be mixed with an inorganic material. Barrier ribs prepared using the photosensitive paste including such a fluoride sol have improved brightness by increasing reflectance compared to conventional photosensitive barrier ribs.

The fluoride may be represented by Chemical Formula 1 or 2 below:

Chemical Formula 1 $M_aF_b$

Chemical Formula 2 $M_xM'_yF_z$

wherein M and M' are one selected from the group consisting of alkali metals, alkali earth metals and Si; and a, b, x, y and z, which represent ratios of the number of atoms, are each independently an integer of 1 to 4 and may be the same or different. In particular, M may be an alkali earth metal and M' may be an alkali metal in order to increase the production yield. Furthermore, M may be magnesium or calcium in terms of availability.

The fluoride sol may be prepared by a process including: preparing a mixture by mixing a water solution of M or M' including a chloride, a nitrate ($NO_3$) salt, a sulfate ($SO_4$) salt, an acetate ($CH_3CO_2$) salt, or the like and a fluoride water solution including NaF, KF, $NH_4K$, HF, or the like; preparing a fluoride precursor by substituting water with an organic solvent; and dispersing the fluoride precursor in the organic material. Meanwhile, a silica sol water solution may further be introduced into the preparation of the fluoride precursor to form a silica-fluoride mixture, and the stability of the fluoride may be secured by the network between the silica and fluoride. In addition, a surface modifier may further be added to the preparation of the fluoride precursor

The fluoride sol prepared by the above-described method may have an average particle diameter of 1 to 60 nm, or more specifically 2 to 40 nm, or even more specifically 4 to 20 nm. Fluorides having an average particle diameter of less than 1 nm are not easily prepared and are not easily dispersed uniformly in an organic material. If the average particle diameter of the fluoride is greater than 60 nm, light transmittance may be reduced since light is scattered during light exposure.

An average refractive index of the fluoride in the fluoride sol may be in the range of 1.3 to 1.45, more particularly 1.3 to 1.4, and an average refractive index of the fluoride sol prepared by dispersing the fluoride precursor in the organic material may be in the range of 1.4 to 1.5. If the average refraction indices of the fluoride and the fluoride sol are not

within the range above, a photosensitive paste composition satisfying the refraction range of Mathematical Formula 1 may not be easily prepared.

Herein, the term "average refractive index of the fluoride sol" refers to an average refractive index of the fluoride not including a solvent. The refraction index of the fluoride sol may be measured using various methods. Herein, the fluoride sol is coated onto a transparent film or a glass substrate and dried at 80 to 120°C for several to several tens of minutes to remove the solvent, and then the refraction index is measured using a refractometer.

The transmittance of a fluoride sol having a thickness of 1 cm may be at least 50% at 500 nm. If the transmittance is less than 50%, photosensitivity of the paste may be decreased during the light exposure. The amount of the fluoride in the fluoride sol may be in the range of 1 to 40 parts by volume based on 100 parts by volume of the organic material. If the amount of the fluoride is less than the range above in the fluoride sol, the reflectance improving efficiency of barrier ribs may be decreased. On the other hand, if the amount of the fluoride is greater than the range above, crosslinking may not sufficiently occur during the light exposure so as not to obtain desired barrier ribs.

The following two conditions may be considered in the mixture of the fluoride sol and the inorganic material. First, average refractive indices of the fluoride sol and the inorganic material may be considered. In particular, the refractive indices of the fluoride sol and the inorganic material may satisfy the relation of Mathematical Formula 1 above, or more specifically, the relation of Mathematical Formula 2 below, or even more specifically, the relation of Mathematical Formula 3 below.

Mathematical Formula 2

$$-0.1 \le N_1 - N_2 \le 0.1$$

Mathematical Formula 3

$$-0.05 \le N_1 - N_2 \le 0.05$$

If the average refractive indices of the fluoride sol and the inorganic material do not meet the relation of Mathematical Formula 1, light transmittance may be decreased so that barrier ribs cannot be formed through a single light exposure process. As the relation between the average refractive indices of the fluoride sol and the inorganic material is close to that of Mathematical Formula 3, photosensitivity can be improved, and the straightness of a pattern of barrier ribs can be increased due to reduced light scattering.

Next, besides the refraction index condition, the amount of the fluoride in the fluoride sol based on the amount of the inorganic material in the photosensitive paste may be considered. The amount of the fluoride may be in the range of 1 to 20 parts by volume, or more specifically, 2 to 10 parts by volume, based on 100 parts by volume of the inorganic material. If the amount of the fluoride is less than the range above, reflectance improving efficiency of barrier ribs may be decreased. On the other hand, if the amount of the fluoride is greater than the range above, sintering properties of the inorganic material may be reduced.

Average thermal expansion coefficients (CTEs, $\alpha$) of the fluoride and the inorganic material may satisfy Mathematical Formula 4 below.

Mathematical Formula 4

$$\text{thermal expansion coefficient of substrate} \times 0.9 \le \alpha \le \text{thermal expansion coefficient of substrate}$$

If the average thermal expansion coefficients of the fluoride and inorganic material do not satisfy the relation of Mathematical Formula 4, the substrate may be seriously distorted or collapse after a calcination process.

The average refractive index of the inorganic material in the photosensitive paste composition according to aspects of the present invention may be in the range of 1.4 to 1.8, more particularly 1.5 to 1.8. If the average refractive index of the inorganic material is not within the range above, the difference of refraction indices between the inorganic

material and the fluoride sol may be too large to form barrier ribs through a single light exposure process.

The inorganic material includes a low melting point glass frit and a high melting point glass frit. The low melting point glass frit in the inorganic material is sintered during a calcination process to form dense barrier ribs, and the high melting point glass frit prevents the structure of the barrier ribs from being collapsed during the calcination process.

The particle shape of the low melting point glass frit is not limited, but may be a spherical shape, since the spherical shape may have excellent filling rate and UV ray transmittance. An average particle diameter of the low melting point glass frit may have a median value $D_{50}$ of 2 to 5 μm, a minimum value $D_{min}$ of 0.1 μm, and a maximum value $D_{max}$ of 20 μm. If the median value is less than 2 μm, or the minimum value is less than 0.1 μm, printing properties may be deteriorated due to decreased dispersibility and a desired pattern of the barrier ribs may not be obtained due to a high shrinkage rate. If the median value is greater than 5 μm, or the maximum value is greater than 20 μm, density of the barrier ribs and straightness of the pattern of barrier ribs may be decreased.

A softening temperature (Ts) of the low melting point glass frit may satisfy Mathematical Formula 5 below.

Mathematical Formula 5

$$\text{sintering temperature} - 80\,^{\circ}\text{C} < Ts < \text{sintering temperature}$$

If the softening temperature of the low melting point glass frit is less than the sintering temperature - 80 °C, the pattern of the barrier ribs may collapse during the calcination process. On the other hand, if the softening temperature is greater than the sintering temperature, sintering may not appropriately occur.

The amount of the low melting point glass frit may be in the range of 70 to 100 parts by volume based on 100 parts by volume of the inorganic material. If the amount of the low melting point glass frit is less than the range above, sintering may not appropriately occur during the calcination process.

The low melting point glass frit may be a complex oxide including at least three oxides selected from the group consisting of oxides of Pb, Bi, Si, B, Al, Ba, Zn, Mg, Ca, P, V, Mo and Te, but is not limited thereto. The low melting point glass frit may be used alone or in a combination of two or more low melting point glass frits. In particular, the low melting point glass frit may be a $PbO-B_2O_3$ based glass, a $PbO-SiO_2-B_2O_3$ based glass, a $Bi_2O_3-B_2O_3$ based glass, a $Bi_2O_3-SiO_2-B_2O_3$ based glass, a $SiO_2-B_2O_3-Al_2O_3$ based glass, a $SiO_2-B_2O_3-BaO$ based glass, a $SiO_2-B_2O_3-CaO$ based glass, a $ZnO-B_2O_3-Al_2O_3$ based glass, a $ZnO-SiO_2-B_2O_3$ based glass, a $P_2O_5$ based glass, a $SnO-P_2O_5$ based glass, a $V_2O_5-P_2O_5$ based glass, a $V_2O_5-Mo_2O_3$ based glass or a $V_2O_5-P_2O_5-TeO_2$ based glass. As used herein, "$P_2O_5$-based glass" and similar terms refer to glasses having at least the named component (e.g. $P_2O_5$), but that can include other components (e.g. oxides). For example, a $P_2O_5$-based glass may include $P_2O_5$ in addition to other oxides.

The particle shape of the high melting point glass frit is not limited, but may be a spherical shape, since the spherical shape may have excellent filling rate and UV ray transmittance. An average particle diameter of the high melting point glass frit may have a median value $D_{50}$ of 1 to 4 μm, a minimum value $D_{min}$ of 0.1 μm, and a maximum value $D_{max}$ of 20 μm. If the median value is less than 1 μm, or the minimum value is less than 0.1 μm, photosensitivity may be decreased and a desired pattern of the barrier ribs may not be obtained due to a high shrinkage rate. If the median value is greater than 4 μm, or the maximum value is greater than 20 μm, density of the barrier ribs and straightness of the pattern of barrier ribs may be decreased.

A softening temperature (Ts) of the high melting point glass frit may satisfy Mathematical Formula 6 below.

Mathematical Formula 6

$$Ts > \text{sintering temperature} + 20\,^{\circ}\text{C}$$

If the softening temperature of the high melting point glass frit is less than the sintering temperature + 20 °C, the pattern of the barrier ribs may collapse during the calcination process.

The amount of the high melting point glass frit may be in the range of 0 to 30 parts by volume based on 100 parts by volume of the inorganic material. If the amount of the high melting point glass frit is greater than the range above, sintering may not appropriately occur during the calcination process.

The high melting point glass frit may be a complex oxide including at least three oxides selected from the group consisting of oxides of Si, B, Al, Ba, Zn, Mg, and Ca, but is not limited thereto. The high melting point glass frit may be used alone or in combination of two or more high melting point glass frits. In particular, the high melting point glass frit may be a $SiO_2-B_2O_3-BaO$ based glass, a $SiO_2-B_2O_3-CaO$ based glass, a $SiO_2-B_2O_3-MgO$ based glass, a

$SiO_2$-$B_2O_3$-CaO-BaO based glass, a $SiO_2$-$B_2O_3$-CaO-MgO based glass, a $SiO_2$-$Al_2O_3$-BaO based glass, a $SiO_2$-$Al_2O_3$-CaO based glass, a $SiO_2$-$Al_2O_3$-MgO based glass, a $SiO_2$-$Al_2O_3$-BaO-CaO based glass or a $SiO_2$-$Al_2O_3$-CaO-MgO based glass.

The average refractive indices of the low melting point glass frit and the high melting point glass frit are in the range of 1.5 to 1.8. In addition, an average refractive index of the low melting point glass frit $N_3$ and an average refractive index of the high melting point glass frit $N_4$ satisfy Mathematical Formula 7 below, or more specifically, satisfy Mathematical Formula 8 below, or even more specifically satisfy Mathematical Formula 9 below.

Mathematical Formula 7

$$-0.2 \leq N_3 - N_4 \leq 0.2$$

Mathematical Formula 8

$$-0.1 \leq N_3 - N_4 \leq 0.1$$

Mathematical Formula 9

$$-0.05 \leq N_3 - N_4 \leq 0.05$$

If the difference of the average refractive indices between the low melting point glass frit and the high melting point glass frit is out of the range shown in Mathematical Formula 7, light transmittance may be decreased so that barrier ribs cannot be formed through a single light exposure process. As the relation between the average refractive indices of the low melting point glass frit and the high melting point glass frit is close to that of Mathematical Formula 9, photosensitivity can be improved, and straightness of a pattern of barrier ribs can be increased due to reduced light scattering.

The organic material may comprise: a binder; a photoinitiator or a photo-acid generator; and a crosslinking agent. Two types of organic materials may be used herein as the organic material into which the fluoride sol is dispersed. The first type of organic material includes an alkali-soluble binder A, a photoinitiator and a crosslinking agent A. During photolithography, a crosslinking reaction is performed at a region exposed to light and the region turns insoluble in an alkali developing solution. The organic material may further include an additive to improve the paste properties and a solvent to control viscosity.

The second type of organic material includes an alkali-soluble binder B, a photo-acid generator and a crosslinking agent B. During photolithography, acid is generated at a region exposed to light and a crosslinking reaction is performed during a subsequent baking process. Then, the region turns insoluble in a developing solution. The organic material may further include an additive to improve the paste properties and a solvent to control viscosity.

The binder A of the first type of organic material may be an acryl-based resin having a carboxyl group that permits development in an alkali developing solution and controls paste properties according to compositional variation. The acryl-based resin having a carboxyl group improves dispersibility of the inorganic material in the photosensitive paste and also adjusts viscosity and elasticity in addition to permitting the development in an alkali developing solution. The acryl-based resin having a carboxyl group may be prepared by copolymerizing a monomer having a carboxyl group and a monomer having an ethylenically unsaturated group.

The monomer having a carboxyl group may include at least one selected from the group consisting of acrylic acid, methacrylic acid, fumaric acid, maleic acid, vinyl acetic acid and anhydrides thereof. The monomer having an ethylenically unsaturated group may include at least one selected from the group consisting of methyl acrylate, ethyl acrylate, n-propyl acrylate, isopropyl acrylate, n-butyl acrylate, sec-butyl acrylate, isobutyl acrylate, tert-butyl acrylate, n-pentyl acrylate, allyl acrylate, phenyl acrylate, benzyl acrylate, butoxyethyl acrylate, butoxytriethyleneglycol acrylate, cyclohexyl acrylate, dicyclopentanyl acrylate, dicyclopentenyl acrylate, 2-ethylhexyl acrylate, glycerol acrylate, glycidyl acrylate, isobornyl acrylate, isodecyl acrylate, isooctyl acrylate, lauryl acrylate, 2-methoxyethyl acrylate, methoxyethyleneglycol acrylate, methoxydiethyleneglycol acrylate, phenoxyethyl acrylate, stearyl acrylate, 1-naphthyl acrylate, 2-naphthyl acrylate, 2-hydroxyethyl acrylate, 2-hydroxypropyl acrylate, aminoethyl acrylate, and the compounds in which

an acrylate moiety thereof is substituted with methacrylate, styrene, α-methylstyrene, α-2-dimethylstyrene, 3-methylstyrene, and 4-methylstyrene.

In addition, the binder A may be a copolymer having a cross-linkable group formed by reacting the carboxyl group of the copolymer with a compound having an ethylenically unsaturated group. The compound having an ethylenically unsaturated group may be acryloyl chloride, methacryloyl chloride, allylchloride, glycidylacrylate, glycidylmethacrylate, 3,4-epoxycyclohexylmethyl acrylate, 3,4-epoxycyclohexylmethyl methacrylate, or the like.

In addition, the binder A may be the copolymer alone or a mixture of the copolymer and at least one selected the group consisting of cellulose, methyl cellulose, ethyl cellulose, n-propyl cellulose, hydroxyethyl cellulose, 2-hydroxyethyl cellulose, methyl 2-hydroxyethyl cellulose, hydroxypropyl cellulose, hydroxypropyl methyl cellulose, hydroxybutyl methyl cellulose, hydroxypropyl methyl cellulose phthalate, cellulose nitrate, cellulose acetate, cellulose triacetate, cellulose acetate butyrate, cellulose acetate hydrogen phthalate, cellulose acetate propionate, cellulose propionate, (acrylamidomethyl)cellulose acetate propionate, (acrylamidomethyl)cellulose acetate butyrate, cyanoethylate cellulose, pectic acid, chitosan, chitin, carboxymethyl cellulose, carboxymethyl cellulose sodium salt, carboxyethyl cellulose, and carboxyethylmethyl cellulose in order to improve membrane leveling or thixotropy characteristics.

A weight average molecular weight of the copolymer may be in the range of 500 to 100,000 g/mol, and an acid value may be in the range of 50 to 300 mgKOH/g. If the weight average molecular weight of the copolymer is less than 500 g/mol, dispersity of the inorganic material in the paste may be reduced. On the other hand, if the weight average molecular weight of the copolymer is greater than 100,000 g/mol, development speed may be too slow or development may not be performed. In addition, if the acid value of the copolymer is less than 50 mgKOH/g, developing properties may be decreased. On the other hand, if the acid value of the copolymer is greater than 300 mgKOH/g, regions exposed to light may also be developed.

The amount of the binder A may be in the range of 30 to 80 parts by weight based on 100 parts by weight of the organic material (the binder A, the photoinitiator and the crosslinking agent). If the amount of the binder A is less than the range above, coating properties of the paste and dispersity may be decreased. On the other hand, if the amount of the binder A is greater than the range above, crosslinking may not sufficiently occur during the light exposure so as not to obtain desired barrier ribs.

The photoinitiator generates radicals in response to light radiated by an light exposure device, and the generated radicals initiate polymerization of the crosslinking agent having an ethylenically unsaturated group to make the paste insoluble in a developing solution. Since the photoinitiator requires high sensitivity, at least two photoinitiators selected from the group listed below may be mixed and used. Examples of the photoinitiator include (i) imidazole-based compounds, (ii) triazine-based compounds, (iii) aminoacetophenone-based compounds, (iv) benzophenone and acetophenone-based compounds (v) benzoin-based compounds, (vi) titanocene-based compounds, (vii) oxadiazole-based compounds, (viii) thioxanthone-based compounds, (ix) (bis)acylphosphine oxide-based compounds, or (x) organic boron salt-based compounds, but are not limited thereto.

The imidazole-based compound may be 2,2'-bis(o-chlorophenyl)-4,4',5,5'-tetraphenyl-1,2'-biimidazole, 2,2'-bis(o-bromophenyl)-4,4',5,5'-tetraphenyl-1,2'-biimidazole, 2,2'-bis(o-chlorophenyl)-4,4',5,5'-tetra(o,p-dichlorophenyl)-1,2'-biimidazole, 2,2'-bis(o,p-dichlorophenyl)-4,4',5,5'-tetra(o,p-dichlorophenyl)-1,2'-biimidazole, 2,2'-bis(o-chlorophenyl)-4,4',5,5'-tetra(m-methoxyphenyl)-1,2'-biimidazole, 2,2'-bis(o-methylphenyl)-4,4',5,5'-tetraphenyl-1,2'-biimidazole, or the like.

The triazine-based compound may be 2,4,6-tris(trichloromethyl)-s-triazine, 2,4,6-tris(tribromomethyl)-s-triazine, 2-propionyl-4,6-bis(trichloromethyl)-s-triazine, 2-benzoyl-4,6-bis(trichloromethyl)-s-triazine, 2-(4-chlorophenyl)-4,6-bis(trichloromethyl)-s-triazine, 2,4-bis(4-methoxyphenyl)-6-trichloromethyl)-s-triazine, 2-(4-methoxyphenyl)-4,6-bis (trichloromethyl)-s-triazine, 2-(4-methoxystyryl)-4,6-bis(trichloromethyl)-s-triazine, 2-(4-chlorostyryl)-4,6-bis(trichloromethyl)-s-triazine, 2-(4-aminophenyl)-4,6-bis(trichloromethyl)-s-triazine, 2,4-bis(3-chlorophenyl)-6-trichloromethyl-s-triazine, 2-(4-aminostyryl)-4,6-bis(dichloromethyl)-s-triazine, or the like.

The aminoacetophenone-based compound may be 2-methyl-2-amino(4-morpholinophenyl)ethane-1-one, 2-ethyl-2-amino(4-morpholinophenyl)ethane-1-one, 2-propyl-2-amino(4-morpholinophenyl)ethane-1-one, 2-butyl-2-amino(4-morpholinophenyl)ethane-1-one, 2-methyl-2-amino(4-morpholinophenyl)propane-1-one, 2-methyl-2-amino(4-morpholinophenyl)butane-1-one, 2-ethyl-2-amino(4-morpholinophenyl)propane-1-one, 2-ethyl-2-amino(4-morpholinophenyl)butane-1-one, 2-methyl-2-methylamino(4-morpholinophenyl)propane-1-one, 2-methyl-2-dimethylamino (4-morpholinophenyl)propane-1-one, 2-methyl-2-diethylamino(4-morpholinophenyl)propane-1-one, or the like.

The benzophenone and acetophenone-based compound may be benzophenone, 4-methylbenzophenone, 2,4,6-trimethylbenzophenone, benzoylbenzoic acid, 4-phenylbenzophenone, 3,3'-dimethyl-4-methoxybenzophenone, 4-benzoyl-4'-methyldiphenylsulfide, 4,4'-bis(N,N-dimethylamino)benzophenone, 4,4'-bis(N,N-diethylamino)benzophenone, 3,3',4,4'-tetra(tert-butylperoxycarbonyl)benzophenone, (2-acryloyloxyethyl)(4-benzoylbenzyl)dimethylammonium bromide, 4-(3-dimethylamino-2-hydroxypropyl)benzophenone, (4-benzoylbenzyl)trimethylammonium chloride, methochloride monohydrate, diethoxyacetophenone, 2-hydroxy-2-methyl-1-phenylpropane-1-one, 1-(4-isopropylphenyl)-2-methylpropane-1-one, 1-hydroxycyclohexylphenylketone, 4-tert-butyl-trichloroacetophenone, or the like.

The benzoin-based compound may be benzoin, benzoinmethyl ether, benzoinethyl ether, benzoinisopropyl ether, benzoinisobutyl ether, or the like.

The titanocene-based compound may be dicyclopentadienyl-Ti-dichloride, dicyclopentadienyl-Ti-diphenyl, dicyclopentadienyl-Ti-bis(2,3,4,5,6-pentafluorophenyl), dicyclopentadienyl-Ti-bis(2,3,5,6-tetrafluorophenyl), dicyclopentadienyl-Ti-bis(2,4,6-trifluorophenyl), dicyclopentadienyl-Ti-bis(2,6-difluorophenyl), dicyclopentadienyl-Ti-bis(2,4-difluorophenyl), bis(methylcyclopentadienyl)-Ti-bis(2,3,4,5,6-pentafluorophenyl), bis(methylcyclopentadienyl)-Ti-bis(2,3,5,6-tetrafluorophenyl), bis(methylcyclopentadienyl)-Ti-bis(2,4,6-trifluorophenyl), bis(methylcyclopentadienyl)-Ti-bis(2,6-difluorophenyl), bis(methylcyclopentadienyl)-Ti-bis(2,4-difluorophenyl), or the like.

The oxadiazole-based compound may be 2-phenyl-5-trichloromethyl-1,3,4-oxadiazole, 2-(p-methylphenyl)-5-trichloromethyl-1,3,4-oxadiazole, 2-(p-methoxyphenyl)-5-trichloromethyl-1,3,4-oxadiazole, 2-styryl-5-trichloromethyl-1,3,4-oxadiazole, 2-(p-methoxystyryl)-5-trichloromethyl-1,3,4-oxadiazole, 2-(p-butoxystyryl)-5-trichloromethyl-1,3,4-oxadiazole, or the like.

The thioxanthone-based compound may be thioxanthone, 2,4-diethylthioxanthone, isopropylthioxanthone, 2,4-diisopropylthioxanthone, 2-chlorothioxanthone, 1-chloro-4-propoxythioxanthone, 2-(3-dimethylamino-2-hydroxypropoxy)-3,4-dimethyl-9H-thioxanthen-9-one methochloride, or the like.

The (bis)acylphosphine oxide-based compound may be 2,4,6-trimethylbenzoyldiphenylphosphineoxide; bis(2,6-dimethoxybenzoyl)-2,4,4-trimethylpentylphosphineoxide, bis(2,6-dichlorobenzoyl)phenylphosphineoxide, bis(2,6-dichlorobenzoyl)-2,5-dimethylphenylphosphineoxide, bis(2,4,6-trimethylbenzoyl)phenylphosphineoxide, or the like.

The organic boron salt-based compound may be a quaternary organic boron salt represented by Chemical Formula 6 below.

Chemical Formula 6

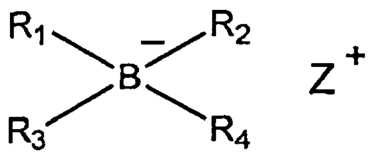

In Chemical Formula 6, $R_1$, $R_2$, $R_3$, and $R_4$ are each independently a substituted or unsubstituted alkyl group, aryl group, aralkyl group, alkenyl group, alkynyl group, silyl group, or heterocyclic group, or a halogen atom, and $Z^+$ is a cation. As specific, non-limiting examples, the substituent may be a methyl group, an ethyl group, an n-propyl group, an isopropyl group, an n-butyl group, a sec-butyl group, an isobutyl group, a tert-butyl group, an n-octyl group, an n-decyl group, an n-dodecyl group, a cyclopentyl group, a cyclohexyl group, a phenyl group, a tolyl group, a xylyl group, an anisyl group, a biphenyl group, a diphenylmethyl group, a methoxy group, an ethoxy group, a n-propoxy group, an isopropoxy group, an n-butoxy group, a sec-butoxy group, an isobutoxy group, a tert-butoxy group, methylenedioxy group, ethylenedioxy group, phenoxy group, naphthoxy group, benzyloxy group, methylthio group, phenylthio group, 2-furyl group, 2-thienyl group, 2-pyridyl group, fluorine group, or the like.

As non-limiting examples, the quaternary organic boron anion of the organic boron salt-based compound may be methyltriphenylborate, n-butyltriphenylborate, n-octyltriphenylborate, n-decyltriphenylborate, n-dodecyltriphenylborate, sec-butyltriphenylborate, tert-butyltriphenylborate, benzyltriphenylborate, n-butyltri(p-anisyl)borate, n-octyltri(p-anisyl)borate, n-dodecyltri(p-anisyl)borate, n-butyltri(p-tolyl)borate, n-butyltri(o-tolyl)borate, n-butyltri(4-tert-butylphenyl)borate, n-butyltri(4-fluoro-2-methylphenyl)borate, n-butyltri(4-fluorophenyl)borate, n-butyltri(1-naphthyl)borate, ethyltri(1-naphthyl)borate, n-butyltri[1-(4-methylnaphthyl)]borate, methyltri[1-(4-methylnaphthyl)]borate, triphenylsilyltriphenylborate, trimethylsilyltriphenylborate, tetra-n-butylborate, di-n-butyldiphenylborate, tetrabenzylborate, or the like. For example, in the quaternary organic boron anion, $R_1$ may be an alkyl group, $R_2$, $R_3$, and $R_4$ may be naphthyl groups in order to maintain stability of the compound and balance of photoreactivity.

The cation $Z^+$ of the organic boron salt may be tetramethylammonium, tetraethylammonium, tetra-n-butylammonium, tetraoctylammonium, N-methylquinolium, N-ethylquinolium, N-methylpyridinium, N-ethylpyridinium, tetramethylphosphonium, tetra-n-butylphosphonium, trimethylsulfonium, triphenylsulfonium, trimethylsulfoxonium, diphenyliodonium, di(4-tert-butylphenyl)iodonium, a lithium cation, a sodium cation, a potassium cation, or the like.

The photoinitiator composition may further include a sensitizer to increase the sensitivity of the photoinitiator. The sensitizer may vary according to the photoinitiator. A photoinitiator may function as a sensitizer of another photoinitiator.
For example, if an imidazole-based photoinitiator is used, a benzophenone-based or thioxanthone-based compound functions as not only a photoinitiator but also a sensitizer of the imidazole-based photoinitiator. Any compound that can absorb light and degrade the organic boron salt compound may be used as the sensitizer for the organic boron salt. The compound may be a benzophenone-based compound, a thioxanthone-based compound, a quinone-based compound, or a cationic dye. The benzophenone-based compound and the thioxanthone-based compound are described above. The quinone-based compound may be quinhydrone, 2,5-dichloro-1,4-benzoquinone, 2,6-dichloro-1,4-benzoquinone, phenyl-1,4-benzoquinone, 2-methyl-1,4-naphthoquinone, 2,3-dichloro-1,4-naphthoquinone, 2-hydroxy-1,4-naphthoquinone, 5-hydroxy-1,4-naphthoquinone, 2-amino-3-chloro-1,4-naphthoquinone, 2-chloro-3-morpholino-1,4-naphthoquinone, anthraquinone, 2-methylanthraquinone, 2-ethylanthraquinone, 2-tert-butylanthraquinone, 2,3-dimethylanthraquinone, 1-chloroanthraquinone, 2-chloroanthraquinone, 1,4-dichloroanthraquinone, 2-(hydroxymethyl)anthraquinone, 9,10-phenanthrenequinone, or the like. The cationic dye generally has a maximum absorption wavelength in the range of 300 nm to near infrared ray region. Thus, the cationic dye has yellow, orange, red, green or blue color, and more particularly, Basic yellow 11, Astrazon orange G, Thioflavin T, Auramine O, Indocyanine green, 1,1',3,3,3',3'-hexamethylindodicarbocyanine iodide, IR-786 perchlorate, or the like.

The amount of the photoinitiator may be in the range of 1 to 20 parts by weight based on 100 parts by weight of the organic material. If the amount of the photoinitiator is less than the range above, the photosensitivity may be decreased. On the other hand, if the amount of the photoinitiator is greater than the range above, regions not exposed to the light may not be developed.

The crosslinking agent A may be a mono acrylate or a multifunctional acrylate. The mono acrylate may be acrylic acid, methyl acrylate, ethyl acrylate, n-propyl acrylate, isopropyl acrylate, n-butyl acrylate, sec-butyl acrylate, isobutyl acrylate, tert-butyl acrylate, n-pentyl acrylate, allyl acrylate, phenyl acrylate, benzyl acrylate, butoxyethyl acrylate, butoxytriethyleneglycol acrylate, cyclohexyl acrylate, dicyclopentanyl acrylate, dicyclopentenyl acrylate, 2-ethylhexyl acrylate, glycerol acrylate, glycidyl acrylate, isobornyl acrylate, isodecyl acrylate, isooctyl acrylate, lauryl acrylate, 2-methoxyethyl acrylate, methoxyethyleneglycol acrylate, methoxydiethyleneglycol acrylate, phenoxyethyl acrylate, stearyl acrylate, 1-naphthyl acrylate, 2-naphthyl acrylate, 2-hydroxyethyl acrylate, 2-hydroxypropyl acrylate, aminoethyl acrylate, and the compounds in which an acrylate moiety thereof is substituted with methacrylate, but is not limited thereto. The multifunctional acrylate may be: a diacrylate such as1,6-hexanediol diacrylate, 1,6-hexanediol(ethoxylate)diacrylate, 1,4-butanediol diacrylate, 2-butyl-2-ethyl-1,3-propanediol diacrylate, 1,9-nonanediol diacrylate, tripropyleneglycol diacrylate, dipropyleneglycol diacrylate, tetraethyleneglycol diacrylate, bisphenol A $(ethoxylate)_n$ (n = 2 to 8) diacrylate, and bisphenol A epoxy diacrylate; a triacrylate such as trimethylolpropane triacrylate, trimethylolpropane(ethoxylate)triacrylate, glycerin(propoxylate)triacrylate, pentaerythritol triacrylate, and
trimethylolpropane(propoxylate)-3-triacrylate; a tetraacrylate such as ditrimethylolpropane tetraacrylate, tetramethylolpropane tetraacrylate, and pentaerythritol tetraacrylate; a pentaacrylate such as dipentaerythritol pentaacrylate; a hexaacrylate such as dipentaerythritol hexaacrylate, or the compounds in which at least one acrylate moiety is substituted with methacrylate, but is not limited thereto.

The amount of the crosslinking agent A may be in the range of 15 to 60 parts by weight based on 100 parts by weight of the organic material. If the amount of the crosslinking agent A is less than the range above, the photosensitivity may be decreased. On the other hand, if the amount of the crosslinking agent A is greater than the range above, the pattern of the barrier ribs may detached or disconnected during sintering.

The binder B of the second type of organic material improves the dispersibility of the inorganic material in the photosensitive paste and also adjusts the viscosity and elasticity in addition to permitting the development in an alkali developing solution. The binder B may be a resin having a phenolic hydroxyl group, a resin having a hydroxystyrene structure, a resin having an epoxy group or a resin having a hydroxyl group and a carboxyl group, but is not limited thereto, and the resins may be used alone or in a combination of two or more.

The resin having a phenolic hydroxyl group may be a novolak resin, which is prepared by condensation-polymerization of a phenol and an aldehyde, or condensation-polymerization of a phenol and a ketone in the presence of an acid. The resin having a hydroxystyrene structure may be prepared by copolyerization of hydroxystyrene or $\alpha$-methyl-hydroxystyrene and acryl-based monomers. The acryl-based monomer may be acrylic esters, methacrylic esters, acrylamide, methacrylamide, acrylonitrile, or the like. The resin having an epoxy group may be a novolak-type epoxy resin, a bisphenol-A-type epoxy resin, an acryl epoxy resin, or the like. The resin having a hydroxyl group and a carboxyl group may be the resin having a phenolic hydroxyl group or a hydroxystyrene structure to which a carboxyl group is added, or a copolymer of an acryl-based (or methacryl-based) monomer having a hydroxyl group and an acryl-based (or methacryl-based) monomer having a carboxyl group.

The weight average molecular weight of binder B may be in the range of 500 to 100,000 g/mol. If the weight average molecular weight of the binder B is less than 500 g/mol, dispersity of the inorganic material in the paste may be reduced. On the other hand, if the weight average molecular weight of the binder B is greater than 100,000 g/mol, development speed may be too slow or development may not be performed.

The amount of the binder B may be in the range of 50 to 95 parts by weight based on 100 parts by weight of the organic material (the binder, the crosslinking agent and the photo-acid generator). If the amount of the binder B is less than the range above, coating properties and dispersity of the paste may be decreased. On the other hand, if the amount of the binder B is greater than the above range, crosslinking may not sufficiently occur during the light exposure and desired barrier ribs may not be obtained.

The photo-acid generator is a material that generates an acid when exposed to light. Non-limiting examples of the photo-acid generator include onium salts, sulfonium salts, organic halogen compounds, naphthoquinone-diazide-sulfonic acids and photoreactive sulfonic acids.

The onium salt or the sulfonium salt may include at least one selected from the group consisting of diphenyliodonium hexafluorophosphate, diphenyliodonium hexafluoro arsenate, diphenyliodium hexafluoro antimonate, diphenylparamethoxyphenylsulfonium triflate, diphenylparatoluenylsulfonium triflate, diphenylparaisobutylphenylsulfonium triflate, diphenylpara-t-butylphenylsulfonium triflate, triphenylsulfonium hexafluoro phosphate, triphenylsulfonium hexafluoro arsenate, triphenylsulfonium hexafluoro antimonate, triphenylsulfonium triflate and dibutylnaphthylsulfonium triflate, but are not limited thereto.

The organic halogen compound may include at least one selected from the group consisting of tribromoacetophenone, phenyltrihalomethyl-sulfone compound, halomethyl-s-triazine compound and halomethyl-oxadiazole compound, but is not limited thereto. The naphthoquinone-diazide-sulfonic acid may include at least one selected from the group consisting of 1,2-naphthoquinone-2-diazide-4-sulfonylchloride and 1,2-naphthoquinone-2-diazide-5-sulfonylchloride, but is not limited thereto.

The photoreactive sulfonic acid may include at least one selected from the group consisting of 1,2-naphthoquinone-2-diazide-4-sulfonic acid ester, 1,2-naphthoquinone-2-diazide-5-sulfonic acid amide, a compound having a β-keto sulfone group, an ester of nitrobenzylalcohol, an ester of arylsulfonic acid, an oxime ester compound, a N-hydroxyamide ester compound, a N-hydroxyimide ester compound, a sulfonic acid ester compound and a benzoic acid ester compound, but is not limited thereto.

The amount of the photo-acid generator may be in the range of 0.1 to 5 parts by weight based on 100 parts by weight of the organic material. If the amount of the photo-acid generator is less than the above range, a crosslinking reaction may not be sufficiently performed. On the other hand, if the amount of the photo-acid generator is greater than the above range, the photo-acid generator absorbs light, thereby decreasing the photosensitivity.

The photo-acid generator may further include a sensitizer in order to improve the photosensitivity. The sensitizer may include at least one selected from the group consisting of anthracene, phenanthracene, 1,2-benzoanthracene, 1,6-diphenyl-1,3,5-hexatriene, 1,1,4,4,-tetraphenyl-1,3-butadiene, 2,3,4,5-tetraphenylfuran, 2,5-diphenylthiophene, thioxanthone, 2-chloro-thioxanthone, phenothiazine, 1,3-diphenylpyrazoline, benzophenone, 4-hydroxy-benzophenone, fluorescein and rhodamine, but is not limited thereto. The amount of the sensitizer may be in the range of 1 to 1000 parts by weight based on 100 parts by weight of the photo-acid generator. If the amount of the sensitizer is less than the above range, sensitizing effects may be decreased. On the other hand, if the amount of the sensitizer is greater than the above range, the sensitizer absorbs the light, thereby decreasing the photosensitivity.

The crosslinking agent B may be a melamine resin, an urea resin, a guanamine resin, a glycoluril-formaldehyde resin, a succinyl amide-formaldehyde resin or an ethylene urea-formaldehyde resin. More specifically, the crosslinking agent B may be a melamine resin and/or a urea resin for crosslinking reactivity and commercialization. Examples of the melamine resin and the urea resin are an alkoxymethylated melamine resin and an alkoxymethylated urea resin. The alkoxymethylated amino resin is prepared by esterifying a condensation product obtained by reacting melamine or urea with formalin using a low molecular weight alcohol such as methyl alcohol, ethyl alcohol and propyl alcohol.

The amount of the crosslinking agent B may be in the range of 5 to 50 parts by weight based on 100 parts by weight of the organic material. If the amount of the crosslinking agent B is less than the above range, the crosslinking reaction may not be sufficiently performed when the organic material is exposed to light, thereby collapsing the pattern during the developing process. On the other hand, if the amount of the crosslinking agent B is greater than the range above, dispersibility and printing properties may deteriorate during a calcination process.

The photosensitive paste composition according to aspects of the present invention may further include one or more additives such as, for example, a polymerization inhibitor and/or an antioxidant that improves preservation properties, a UV ray absorbing agent that improves resolution, an antifoaming agent that reduces foams in the composition, a dispersing agent that improves dispersibility, a leveling agent that improves flatness of membranes during printing, a plasticizer that improves thermal degradation properties, and a thixotropic agent that provides thixotropy characteristics.

The solvent may be any solvent that does not decrease dispersibility of the fluoride, can dissolve the binder A, the binder B, the photoinitiator and the photo-acid generator, can be easily mixed with the crosslinking agent and other additives, and has a boiling point of 150 °C or higher. If the boiling point of the solvent is less than 150 °C, the solvent may be easily evaporated during a preparation process of the composition, in particular, during a 3-roll mill process, and printing quality may be decreased since the solvent is quickly evaporated during the printing process. The solvent may

be at least one selected from the group consisting of ethyl carbitol, butyl carbitol, ethyl carbitol acetate, butyl carbitol acetate, texanol, terpine oil, diethylene glycol, dipropylene glycol, tripropylene glycol, dipropyleneglycol methyl ether, dipropyleneglycol ethyl ether, dipropyleneglycol monomethyl ether acetate, γ-butyrolactone, cellosolve acetate and butylcellosolve acetate, but is not limited thereto.

The amount of the solvent is not particularly limited, but may be adjusted to provide a viscosity suitable for printing or coating.

The photosensitive paste composition according to aspects of the present invention may be prepared according to the following process.

First, a fluoride sol is prepared. The fluoride sol may be prepared by preparing a fluoride precursor by substituting water in a water soluble fluoride gel with an organic solvent, and dispersing the fluoride precursor in the organic material. The organic material is previously prepared to a uniform and transparent solution by mixing each of the organic components and sufficiently stirring the mixture. The prepared fluoride sol is mixed with an inorganic material to prepare a paste. The paste is mixed using a planetary mixer PLM, or the like, and mechanically mixed several times using 3-roll mill. After the 3-roll milling process is completed, a filtering process is performed using, for example, SUS mesh #400, and degassing is performed using a vacuum pump to prepare a photosensitive paste composition.

According to another embodiment of the present invention, barrier ribs for a plasma display panel (PDP) prepared using the photosensitive paste composition are provided. The process of preparing the PDP barrier ribs using the photosensitive paste composition may vary according to types of components in the organic material.

If the photosensitive paste composition is prepared using the first type of organic material including the alkali-soluble binder A, the photoinitiator and the crosslinking agent A, barrier ribs are prepared according to the following process. The photosensitive paste composition is coated using screen printing or a table coater onto a lower panel of a PDP on which an address electrode and a dielectric layer have been formed. Most of the solvent is removed by drying the resultant in a dry oven or an infrared ray (IR) oven at 80 to 120 °C for 5 to 60 minutes. Then, the dried film is exposed to light using an ultraviolet ray exposure device having a photomask to initiate crosslinking reactions on regions exposed to the light. The resultant is developed using a suitable alkali developing solution such as an $Na_2CO_3$ solution, a KOH solution, a tetramethyl ammonium hydroxide (TMAH) solution or a monoethanol amine solution, which are diluted in pure water, at about 30 °C to remove regions not exposed to the light and to obtain a pattern. Then, a calcination process is performed in an electric furnace or the like at 500 to 600 °C for 5 to 60 minutes to remove residual organic materials and sinter the low melting point glass frit. Thus, patternized barrier ribs may be obtained.

If the photosensitive paste composition is prepared using the second-type organic material including the alkali-soluble binder B, the photo-acid generator and the crosslinking agent B, barrier ribs are prepared in the same manner as in the above process using the first type of organic material except that when the light exposure process is performed using the ultraviolet ray exposure device, an acid is generated in the regions exposed to light instead of crosslinking reactions occurring. The crosslinking reactions of the second type of organic material occur during a subsequent heat-treatment at 80 to 150 °C for 5 to 60 minutes. Then, subsequent developing and calcination processes are the same as those described with reference to the first-type organic material.

According to another embodiment of the present invention, a plasma display panel (PDP) including the barrier ribs is provided.

FIG. 1 is a perspective view of a plasma display panel (PDP) according to an embodiment of the present invention.

A PDP according to the present invention includes a front panel 110 and a rear panel 120. The front panel 110 includes a front substrate 111, pairs of sustain electrodes 114 including a Y electrode 112 and an X electrode formed on a rear surface of the front substrate 111 a, a front dielectric layer 115 covering the pairs of sustain electrodes 114, and a protection layer 116 covering the front dielectric layer 115. Each of the Y electrode 112 and X electrode 113 includes: transparent electrodes 112b and 113b formed of ITO, or the like; and bus electrodes112a and 113a including a black electrode (not shown) to improve brightness and a white electrode (not shown) to provide conductivity. The bus electrodes112a and 113a are connected to cables arrayed in both sides of the PDP.

The rear panel 120 includes a rear substrate 121, address electrodes 122 formed on the front surface of the rear substrate 121 a to cross the pairs of sustain electrodes, a rear dielectric layer 123 covering the address electrodes 122, barrier ribs 124 formed on the rear dielectric layer 123 and dividing emission cells 126, and a phosphor layer 125 disposed in the emission cells. The address electrodes 122 are connected to cables arrayed in the top and bottom of the PDP.

Aspects of the present invention will be described in greater detail with reference to the following examples. The following examples are for illustrative purposes and are not intended to limit the scope of the invention.

Examples

Preparation of Fluoride Precursor

Preparation Example 1. Preparation of Magnesium Fluoride ($MgF_2$) Precursor

A magnesium chloride water solution was prepared by dissolving 203.3 g of magnesium chloride ($MgCl_2 \cdot 6H_2O$) in 5 L of ion exchanged water, and a potassium fluoride water solution was prepared by dissolving 188.26 g of potassium fluoride ($KF \cdot 2H_2O$) in 5 L of ion exchanged water. 10 L of ion exchanged water was added to a 50 L reactor and the magnesium chloride water solution and the potassium fluoride water solution were simultaneously added to the reactor at a rate of 10 ml/sec while fiercely stirring. Then, the mixture was concentrated using a vacuum concentration device until the volume of the mixture reached 2 L. The concentrated solution was matured by heating at 95°C for 24 hours to prepare a gel. Then, electrolytes were removed from the gel using an ultrafiltration membrane, and the resultant was concentrated again using the vacuum concentration device until the volume of the mixture reached 1 L to prepare an aqueous magnesium fluoride sol. The aqueous magnesium fluoride sol was treated in a solvent exchange device using 1 L of diethylene glycol to prepare a magnesium fluoride precursor dispersed in diethylene glycol.

Preparation Example 2. Preparation of Sodium Magnesium Fluoride ($NaMgF_3$) Precursor

A sodium magnesium fluoride ($NaMgF_3$) precursor dispersed in diethylene glycol was prepared in the same manner as in Preparation Example 1, except that a sodium fluoride water solution, which was prepared by dissolving 126 g of sodium fluoride (NaF) in 5 L of ion exchanged water, was used instead of the potassium fluoride water solution.

Preparation Example 3 Preparation of Silica-Magnesium Fluoride ($SiO_2$-$MgF_2$ Precursor

A magnesium chloride water solution was prepared by dissolving 203.3 g of magnesium chloride ($MgCl_2 \cdot 6H_2O$) in 5 L of ion exchanged water, a silica sol water solution was prepared by diluting 300 g of silica sol (10 wt%, average particle diameter: 5 nm) in 5 L of ion exchanged water, and an ammonium fluoride water solution was prepared by dissolving 74.08 g of ammonium fluoride ($NH_4F$) in 5 L of ion exchanged water. The prepared silica sol water solution was added to a 50 L reactor and the magnesium chloride water solution was added to the reactor at a rate of 10 ml/sec while fiercely stirring. Then, 300 g of 0.1 N hydrochloric acid solution was added thereto. Then, the ammonium fluoride water solution was added to the reactor at a rate of 10 ml/sec. Then, a silica-magnesium fluoride precursor dispersed in diethylene glycol was prepared in the same manner as in Preparation Example 1.

Measuring Physical Properties of Fluoride

The refractive index (@ 589 nm, 20 °C), specific gravity (@ 20 °C), transmittance (@ 20 °C) and average particle diameter (@ 20 °C) of the three types of fluoride precursors prepared according to Preparation Examples 1 to 3 were measured, and the results are shown in Table 1 below. The transmittance was measured at 500 nm when the thickness of the fluoride was 1 cm, and the average particle diameter was measured using Photon Correlation Spectroscopy (PCS).

Table 1

| Fluoride | Refractive index | Specific gravity | Transmittance (%) | Average particle diameter (nm) |
|---|---|---|---|---|
| $MgF_2$ | 1.37 | 3.1 | 72 | 15.3 |
| $NaMgF_3$ | 1.33 | 2.8 | 68 | 17.5 |
| $SiO_2$-$MgF_2$ | 1.41 | 2.9 | 84 | 12.6 |

Preparation of Organic Material

Organic materials to be mixed with the prepared fluoride precursors and used to prepare a fluoride sol were prepared according to the following process.

Preparation Example 4. Preparation of Organic Material 1

An organic mixture including 79.4 wt% of a binder (a novolak resin (prepared by adding formalin to m-cresol in the presence of an oxalic acid catalyst), weight average molecular weight: 18,000 g/mol), 19.0 wt% of a crosslinking agent (hexamethoxymethyl-melamine), and 1.6 wt% of a photo-acid generator (triphenylsulfonium triflate) was prepared. Organic Material 1 was prepared by adding 30 parts by weight of a solvent (ethylcarbitol) based on 100 parts by weight of the organic mixture to the organic mixture in order to control the solubility and viscosity.

Preparation Example 5. Preparation of Organic Material 2

An organic mixture including 54.0 wt% of a binder (poly(styrene-co-methylmethacrylic acid) copolymer, weight average molecular weight: 12,000 g/mol, acid value: 180 mgKOH/g), 9.5 wt% of a photoinitiator (2-benzyl-2-dimethylamino-1-(4-morpholinophenyl)-1-butanone), 29.5 wt% of a crosslinking agent (bisphenol A modified epoxy diacrylate), and 7.0 wt% of a stabilizing agent for storage (benzotriazole). Organic Material 2 was prepared by adding 15 parts by weight of a solvent (ethylcarbitol) based on 100 parts by weight of the organic mixture to the organic mixture in order to control the solubility and viscosity.

Preparation Example 6. Preparation of Organic Material 3

An organic mixture including 60.0 wt% of a binder 1 (poly(methyl methacrylate-co-butyl methacrylate-co-methyl methacrylic acid) copolymer, weight average molecular weight: 12,000 g/mol, acid value 150 mgKOH/g), 2.0 wt% of a binder 2 (hydroxypropyl cellulose, weight average molecular weight: 80,000 g/mol), 1.5 wt% of a photoinitiator 1 (2-methyl-1-[4-(methylthio)phenyl]-2-morpholinopropane-1-one), 0.5 wt% of a photoinitiator 2 (2,4-diethylthioxanthone), 25.0 wt% of a crosslinking agent 1 (methoxydiethyleneglycol acrylate), 10 wt% of a crosslinking agent 2 (trimethylolpropane triacrylate), and 1.0 wt% of a stabilizing agent for storage (malic acid). Organic Material 3 was prepared by adding 20 parts by weight of a solvent (texanol) based on 100 parts by weight of the organic mixture to the organic mixture in order to control solubility and viscosity,

Evaluation of Physical Properties of the Organic Materials

Refractive index and specific gravity of the organic materials prepared according to Preparation Example 4 to 6 were measured, and the results are shown in Table 2

Table 2

| Organic Material | Refractive index (@ 20°C) | Specific gravity (@ 20°C) |
|---|---|---|
| Organic Material 1 | 1.55 | 1.14 |
| Organic Material 2 | 1.57 | 1.15 |
| Organic Material 3 | 1.47 | 1.07 |

Preparation of Fluoride Sol

Fluoride sols were prepared by respectively dispersing fluoride precursors prepared according to Preparation Examples 1 to 3 into the organic materials prepared according to Preparation Examples 4 to 6. In particular, the fluoride sols were prepared by adding the organic material to a stirring reactor, gradually adding a predetermined amount of the fluoride precursor to the reactor while stirring, and stirring the reactor for several hours. The volume ratios used in Preparation Examples 6 to 8 are based on the volumes without the solvent.

Preparation Example 7. Preparation of Fluoride Sol 1

The $MgF_2$ precursor prepared according to Preparation Example 1 and the Organic Material 1 prepared according to Preparation Example 4 were mixed at a volume ratio of 30:70. The measured refractive index was 1.50.

Preparation Example 8. Preparation of Fluoride Sol 2

The $NaMgF_3$ precursor prepared according to Preparation Example 2 and the Organic Material 2 prepared

according to Preparation Example 5 were mixed at a volume ratio of 30:70. The measured refractive index was 1.50.

Preparation Example 9. Preparation of Fluoride Sol 3

The $SiO_2$-$MgF_2$ precursor prepared according to Preparation Example 3 and the Organic Material 3 prepared according to Preparation Example 6 were mixed at a volume ratio of 30:70. The measured refractive index was 1.45.

Preparation of Photosensitive Paste Composition

A photosensitive paste composition according to aspects of the present invention was prepared by mixing Fluoride Sols 1 to 3 prepared according to Preparation Examples 7 to 9 with an inorganic material including a low melting point glass frit and a high melting point glass frit according to Examples 1 to 3 below. In addition, a photosensitive paste composition without a fluoride was prepared as shown in Comparative Example 1 below. Here, the volume ratios used in Examples 1 to 3 and Comparative Example 1 are based on the volumes without the solvent.

Example 1. Preparation of Photosensitive Paste Composition 1

Photosensitive Paste Composition 1 including 45 vol% of Fluoride Sol 1 prepared according to Preparation Example 7, 50 vol% of a low melting point glass frit ($SiO_2$-$B_2O_3$-$Al_2O_3$-F based glass, amorphous, $D_{50}$ = 3.4 μm, refractive index = 1.47), and 5 vol% of a high melting point glass frit ($SiO_2$-$B_2O_3$-$Al_2O_3$ based glass, amorphous, $D_{50}$ = 2.5 μm, refractive index = 1.46) was prepared using a method of preparing the paste composition.

Example 2. Preparation of Photosensitive Paste Composition 2

Photosensitive Paste Composition 2 was prepared in the same manner as in Example 1 except that Fluoride Sol 2 prepared according to Preparation Example 8 was used instead of Fluoride Sol 1 of Preparation Example 7.

Example 3. Preparation of Photosensitive Paste Composition 3

Photosensitive Paste Composition 3 was prepared in the same manner as in Example 1 except that Fluoride Sol 3 prepared according to Preparation Example 9 was used instead of Fluoride Sol 1 of Preparation Example 7.

Comparative Example 1. Preparation of Photosensitive Paste without Fluoride

A photosensitive paste composition without a fluoride including 40 vol% of Organic Material 3 prepared according to Preparation Example 6, 50 vol% of a low melting point glass frit ($SiO_2$-$B_2O_3$-$Al_2O_3$-F based glass, amorphous, $D_{50}$ = 3.4 μm, refractive index = 1.47), and 10 vol% of a high melting point glass frit ($SiO_2$-$B_2O_3$-$Al_2O_3$ based glass, amorphous, $D_{50}$ = 2.5 μm, refractive index = 1.46) was prepared.

Evaluation of Photosensitive Paste Composition

Barrier ribs were prepared using the photosensitive paste compositions prepared according to Examples 1 to 3 and Comparative Example 1 by the following process.

The photosensitive paste compositions prepared according to Examples 1 to 3 and Comparative Example 1 were coated onto a 6" glass substrate using a coater, and dried in a dry oven at 100°C for 30 minutes to form a dry film having a thickness of 180 μm. Then, light exposure was performed using a high pressure mercury lamp UV exposing unit including a photomask having a lattice pattern (width:line width = 40 μm (pitch = 160 μm), length:line width = 40 μm (pitch = 560 μm)) at 300 to 1000 $mJ/cm^2$. Then, only the glass substrate on which Photosensitive Paste Composition 1 of Example 1 was coated was heat-treated in a dry oven at 120 °C for 10 minutes to perform a developing process. The other Photosensitive Paste Compositions 2 and 3 and the photosensitive paste composition without a fluoride were directly developed. The developing process was performed by spraying a 0.8 wt% sodium carbonate water solution at a nozzle pressure of 1.5 $kgf/cm^2$ at 35°C for 200 seconds, and then performing a washing process by spraying pure water at a nozzle pressure of 1.2 $kgf/cm^2$ at room temperature for 30 seconds. Then, the glass was dried using an air knife, and a calcination was performed in an electrical furnace at 560°C for 20 minutes to form barrier ribs. Then, the formed barrier ribs were evaluated using an optical microscope and a scanning electron microscope (SEM).

The results of the evaluation of the barrier ribs are shown in Table 3 below. In Table 3, the exposure amount was a value showing an optimized pattern, and the color of barrier ribs was observed with the naked eye.

Table 3

| Photosensitive paste composition | Exposure amount (mJ/cm$^2$) | Thickness of calcined film | Upper width | Lower width | Color of barrier ribs |
|---|---|---|---|---|---|
| Example 1 | 700 | 122 μm | 48 μm | 55 μm | white |
| Example 2 | 700 | 123 μm | 47 μm | 54 μm | white |
| Example 3 | 600 | 124 μm | 43 μm | 60 μm | white |
| Comparative Example 1 | 400 | 122 μm | 38 μm | 63 μm | gray |

The results of Table 3 can be interpreted as follows. The photosensitivity (exposure amount) depends on the difference between refractive indexes of the fluoride sol and the inorganic material. That is, the photosensitive paste composition of Example 3 having a small difference of the refractive index has excellent photosensitivity among those of Examples 1 to 3. In addition, as shown in the results of Table 3, as the photosensitivity is decreased, the upper width is increased and the lower width is decreased. This result indicates that light transmittance is decreased and reflection and scattering are increased as the difference of the refractive index between the fluoride sol and the inorganic material is increased. According to Table 3, the color of the barrier ribs including the fluoride was white but the color of the barrier ribs without the fluoride was gray, and this result indicates that reflectance to visible rays is different in Comparative Example 1.

Manufacturing Plasma Display Panel (PDP) and Evaluation Properties of the PDP

A 6" panel was manufactured using the photosensitive paste compositions prepared according to Examples 1 to 3. In addition, a panel was manufactured using the photosensitive paste composition according to Comparative Example 1.

Each 6" panel was manufactured in a pilot line and had specs for a 42" HD panel. The brightness of the panels was evaluated and the results are shown in Table 4.

Table 4

| Photosensitive Paste Composition | Brightness (lm/W) | Relative brightness ratio |
|---|---|---|
| Example 1 | 1.33 | 117 |
| Example 2 | 1.36 | 119 |
| Example 3 | 1.31 | 115 |
| Comparative Example 1 | 1.14 | 100 |

Referring to the brightness results shown in Table 4, if the photosensitive paste composition of Examples 1 to 3 is used, brightness can be increased by about 15 to 20% compared to the photosensitive paste composition of Comparative Example 1. As described above, the brightness can be increased since the fluoride increased reflectance of the barrier ribs.

According to aspects of the present invention, a plasma display panel (PDP) having high brightness can be manufactured since the barrier ribs have high reflectance compared to conventional barrier ribs.

Although a few embodiments of the present invention have been shown and described, it would be appreciated by those skilled in the art that changes may be made in this embodiment without departing from the principles of the invention, the scope of which is defined in the claims and their equivalents.

## Claims

**1.** A photosensitive paste composition comprising:

a fluoride sol dispersed in an organic material; and

an inorganic material,

wherein an average refractive index of the fluoride sol $N_1$ and an average refractive index of the inorganic material $N_2$ satisfy Mathematical Formula 1 below:

Mathematical Formula 1

$$-0.2 \leq N_1 - N_2 \leq 0.2.$$

2. A photosensitive paste composition according to claim 1, wherein the fluoride in the fluoride sol is represented by Chemical Formula 1 or 2 below:

Chemical Formula 1 $M_aF_b$

Chemical Formula 2 $M_xM'_yF_z$

wherein M and M' are different and are each selected from the group consisting of alkali metals, alkali earth metals and Si; and
a, b, x, y and z represent ratios of the number of atoms and are each independently an integer of 1 to 4.

3. A photosensitive paste composition according to claim 1 or 2, wherein the fluoride sol is prepared by a process comprising:

preparing a mixture by mixing a first water solution including a compound represented by Chemical Formula 3 or 4 below and a second water solution including a compound represented by Chemical Formula 5;
preparing a fluoride precursor by substituting water in the mixture with an organic solvent; and

dispersing the fluoride precursor in the organic material:

Chemical Formula 3 $M_aX_b$,

Chemical Formula 4 $M_xM'_yX_z$

Chemical Formula 5 $A_tF_u$

wherein M and M' are different and are each selected from the group consisting of alkali metals, alkali earth metals and Si;

X is Cl, $NO_3$, $SO_4$ or $CH_3CO_2$;
A is Na, K, NH4 or H;

a, b, t, u, x, y and z represent ratios of the number of atoms and are each independently an integer of 1 to 4.

4. A photosensitive paste composition according to any one of claims 1 to 3, wherein the fluoride in the fluoride sol is a silica-fluoride mixture.

5. A photosensitive paste composition according to any one of claims 1 to 4, wherein the fluoride in the fluoride sol has an average particle diameter of 1 to 60 nm.

6. A photosensitive paste composition according to any one of claims 1 to 5, wherein the average refractive index of the fluoride sol is in the range of from 1.4 to 1.5.

7. A photosensitive paste composition according to any one of claims 2 to 6, wherein an average refractive index of the fluoride in the fluoride sol is in the range of from 1.3 to 1.4.

8. A photosensitive paste composition according to any one of claims 1 to 7, wherein a transmittance of the fluoride

sol having a thickness of 1 cm is 50% or greater at 500 nm.

**9.** A photosensitive paste composition according to any one of claims 1 to 8, wherein the average refractive index of the fluoride sol $N_1$ and the average refractive index of the inorganic material $N_2$ satisfy Mathematical Formula 2 below:

Mathematical Formula 2

$$-0.1 \leq N_1 - N_2 \leq 0.1.$$

**10.** A photosensitive paste composition according to any one of claims 1 to 9, wherein the amount of the fluoride in the fluoride sol is in the range of 1 to 40 parts by volume based on 100 parts by volume of the organic material.

**11.** A photosensitive paste composition according to any one of claims 1 to 10, wherein the average refractive index of the inorganic material $N_2$ is in the range of 1.5 to 1.8.

**12.** A photosensitive paste composition according to any one of claims 1 to 11, wherein the inorganic material comprises low melting point glass frit having a softening temperature Ts satisfying Mathematical Formula 5 below and high melting point glass frit having a softening temperature Ts satisfying Mathematical Formula 6 below:

Mathematical Formula 5

sintering temperature - 80 °C < Ts of the low melting point glass frit < sintering temperature,

Mathematical Formula 6

Ts of the high melting point glass frit > sintering temperature + 20 °C.

**13.** A photosensitive paste composition according to claim 12, wherein an average particle diameter of the low melting point glass frit has a median value $D_{50}$ of 2 to 5 μm, a minimum value $D_{min}$ of 0.1 μm, and a maximum value $D_{max}$ of 20 μm.

**14.** A photosensitive paste composition according to claim 12 or 13, wherein the amount of the low melting point glass frit is in the range of 70 to 100 parts by volume based on 100 parts by volume of the inorganic material.

**15.** A photosensitive paste composition according to any one of claims 12 to 14, wherein the low melting point glass frit is at least one selected from the group consisting of a $PbO$-$B_2O_3$ based glass, a $PbO$-$SiO_2$-$B_2O_3$ based glass, a $Bi_2O_3$-$B_2O_3$ based glass, a $Bi_2O_3$-$SiO_2$-$B_2O_3$ based glass, a $SiO_2$-$B_2O_3$-$Al_2O_3$ based glass, a $SiO_2$-$B_2O_3$-$BaO$ based glass, a $SiO_2$-$B_2O_3$-$CaO$ based glass, a $ZnO$-$B_2O_3$-$Al_2O_3$ based glass, a $ZnO$-$SiO_2$-$B_2O_3$ based glass, a $P_2O_5$ based glass, a $SnO$-$P_2O_5$ based glass, a $V_2O_5$-$P_2O_5$ based glass, a $V_2O_5$-$Mo_2O_3$ based glass and a $V_2O_5$-$P_2O_5$-$TeO_2$ based glass.

**16.** A photosensitive paste composition according to any one of claims 12 to 15, wherein an average particle diameter of the high melting point glass frit has a median value $D_{50}$ of 1 to 4 μm, a minimum value $D_{min}$ of 0.1 μm, and a maximum value $D_{max}$ of 20 μm.

**17.** A photosensitive paste composition according to any one of claims 12 to 16, wherein the amount of the high melting point glass frit is in the range of 0 to 30 parts by volume based on 100 parts by volume of the inorganic material.

**18.** A photosensitive paste composition according to any one of claims 12 to 17, wherein the high melting point glass frit is at least one selected from the group consisting of a $SiO_2$-$B_2O_3$-$BaO$ based glass, a $SiO_2$-$B_2O_3$-$CaO$ based glass, a $SiO_2$-$B_2O_3$-$MgO$ based glass, a $SiO_2$-$B_2O_3$-$CaO$-$BaO$ based glass, a $SiO_2$-$B_2O_3$-$CaO$-$MgO$ based glass, a $SiO_2$-$Al_2O_3$-$BaO$ based glass, a $SiO_2$-$Al_2O_3$-$CaO$ based glass, a $SiO_2$-$Al_2O_3$-$MgO$ based glass, a $SiO_2$-$Al_2O_3$-$BaO$-

CaO based glass and a $SiO_2$-$Al_2O_3$-CaO-MgO based glass.

**19.** A photosensitive paste composition according to any one of claims 12 to 17, wherein an average refractive index of the low melting point glass frit $N_3$ and an average refractive index of the high melting point glass frit $N_4$ satisfy Mathematical Formula 7 below:

Mathematical Formula 7

$$-0.2 \leq N_3 - N_4 \leq 0.2.$$

**20.** A plasma display panel (PDP) comprising barrier ribs prepared by patterning the photosensitive paste composition according to any one of claims 1 to 19.

FIG. 1

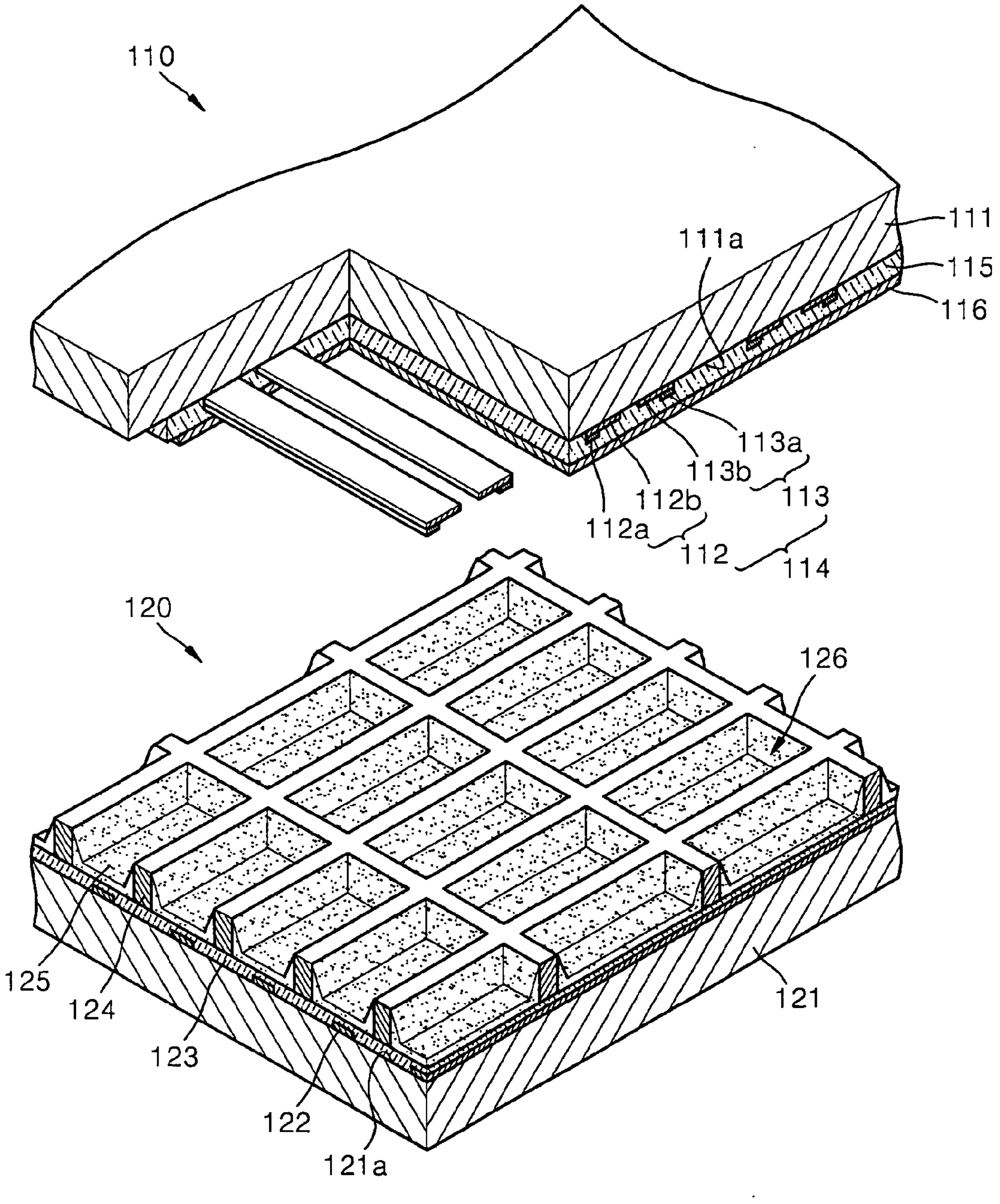
110
111
111a
115
116
113a
113b
113
112b
112a
112
114
120
126
125
124
123
122
121a
121

Europäisches Patentamt
European Patent Office
Office européen des brevets

# EUROPEAN SEARCH REPORT

Application Number
EP 09 25 0171

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2004/012854 A (ULTRA PLASMA DISPLAY CORP [KR]; ILDONG CHEMICAL CO LTD [KR]; PARK LEE) 12 February 2004 (2004-02-12)<br>* page 4, lines 14-28; claims 1-15 *<br>----- | 1-20 | INV.<br>C03C8/22<br>G03F7/004<br>C03C8/24<br>H01J9/26 |
| Y | WERNER VOGEL: "Glaschemie"<br>1992, SPRINGER-VERLAG , XP007908259<br>* pages 310-312 *<br>----- | 1-20 | |
| Y | DATABASE WPI Week 200032<br>Thomson Scientific, London, GB; AN 2000-368948<br>XP002524619<br>-& JP 2000 095544 A (MITSUBISHI MATERIALS CORP) 4 April 2000 (2000-04-04)<br>* abstract *<br>----- | 1-20 | |
| | | | TECHNICAL FIELDS SEARCHED (IPC) |
| | | | C03C<br>G03F<br>H01J |

The present search report has been drawn up for all claims

1

| Place of search | Date of completion of the search | Examiner |
|---|---|---|
| The Hague | 21 April 2009 | Flügel, Alexander |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 09 25 0171

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2009

| Patent document cited in search report | Publication date | Patent family member(s) | Publication date |
|---|---|---|---|
| WO 2004012854 A | 12-02-2004 | AU 2003248494 A1 | 23-02-2004 |
| | | CN 1791561 A | 21-06-2006 |
| | | JP 2006502942 T | 26-01-2006 |
| | | KR 20040012298 A | 11-02-2004 |
| JP 2000095544 A | 04-04-2000 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6197480 B
- US 6117614 A